# EUROPÄISCHE PATENTSCHRIFT

(11) **EP 0 326 780 B1**
(45) Veröffentlichungstag und Bekanntmachung des Hinweises auf die Patenterteilung: **11.04.2001**
(21) Anmeldenummer: 88710055.0
(22) Anmeldetag: 17.12.1988
(51) Int. Cl.: H01L 23/52, H01L 29/06, H01L 29/73

(54) **Leistungstransistor**
Power transistor
Transistor de puissance

(30) Priorität: 30.01.1988 DE 3802794
(43) Veröffentlichungstag der Anmeldung: 09.08.1989
(73) Patentinhaber: ROBERT BOSCH GMBH, 70442 Stuttgart (DE)
(72) Erfinder: Conzelmann, Gerhard, Dipl.-Phys., D-7022 Leinfelden-Oberaichen (DE); Nagel, Karl, D-7413 Gomaringen (DE); Fiedler, Gerhard, Dipl.-Ing. (FH), D-7441 Neckartailfingen (DE)

(56) Entgegenhaltungen:
- WO-A-87/01867

## Beschreibung

### Stand der Technik

Die Erfindung betrifft einen monolithisch integrierten, in Bipolar-Epitaxial-Technik ausgeführten Leistungstransistor nach der Gattung des Hauptanspruchs.

Aus der US-PS 40 38 677 ist bereits ein monolithisch integrierter Leistungstransistor dieser Art bekannt, bei dem auch in die Emitter- und in die Basisleitung jedes Teiltransistors je eine Brennstrecke geschaltet ist. Mit Hilfe dieser Brennstrecken, die gleichzeitig als Meßwiderstände dienen, wird bei dem bekannten Leistungstransistor die Möglichkeit geschaffen, im Laufe seiner Herstellung defekte Teiltransistoren zu erkennen und hierauf mit Hilfe eines an die jeweiligen Brennstrecken der defekten Teiltransistoren angelegten Spannungsstoßes die defekten Teiltransistoren von dem verbleibenden guten Teil des Leistungstransistors durch Abbrennen der Brennstrecken abzutrennen.

Aus der WO 87/01867 ist ein Leistungstransistor bekannt, der aus einer Parallelschaltung einzelner Transistorzellen besteht und die Merkmale der Oberbegriffe der Ansprüche 1 und 2 aufweist. In der Emitterleitung dieser Transistorzellen sind Brennstrecken angeordnet, die bei einem Defekt der Transistorzelle infolge der großen Strombelastung durchbrennen.

### Vorteile der Erfindung

Die erfindungsgemäßen monolithisch integrierten Leistungstransistoren mit den kennzeichnenden Merkmalen der Ansprüche 1 and 2 haben demgegenüber den Vorteil, daß die Leistungstransistoren selbstheilend sind d.h. daß beim Auftreten eines Defekts in einem Teiltransistor bzw. in einer Transistorzelle des Leistungstransistors dieser Teiltransistor bzw. diese Zelle sich selbsttätig vom verbleibenden guten Teil des Leistungstransistors abtrennt. Weitere Vorteile ergeben sich aus der Beschreibung.

### Zeichnung

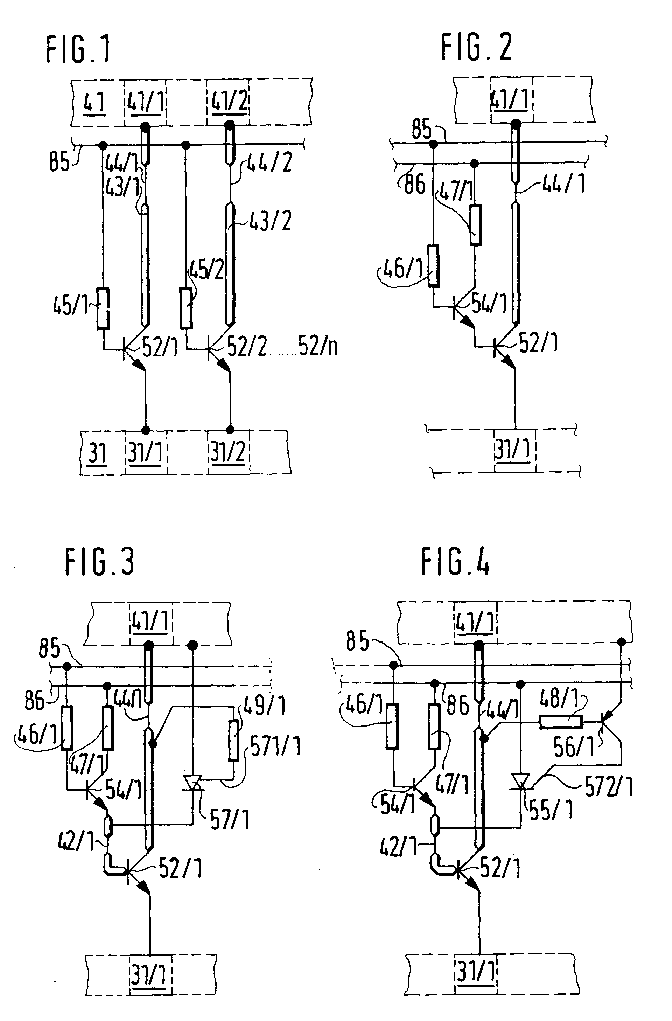

Ausführungsbeispiele der Erfindung sind in der Zeichnung dargestellt und in der nachfolgenden Beschreibung näher erläutert. Figur 1 zeigt eine Anordnung, die nicht Teil der Erfindung ist. Die Figuren 2 bis 4 zeigen je eines der Ausführungsbeispiele, ein viertes ist aus Figur 2 herleitbar.

### Beschreibung der Ausführungsbeispiele

Kostengünstig zu fertigende monolithisch integrierte Leistungstransistoren erfordern eine hohe Flächenleistungsdichte, wie sie beispielsweise durch Löten des Chips auf eine Kupfergrundplatte zu erreichen ist. Da es in einer Großserie jedoch nicht gelingt, absolut lunkerfrei zu löten und bei der Schlußprüfung Exemplare mit feinen Lunkern sicher zu erfassen, ist ein "Selbstheileffekt" unabdingbar, um eine hohe Zuverlässigkeit zu erreichen. Es wird deshalb vorgeschlagen, die Kollektoren der einzelnen Zellen gegeneinander zu isolieren und in die Kollektorzuleitung zum Anschlußfleck eine Engstelle einzubauen. Wird ein Teil einer Zelle oder auch mehrerer Zellen durch einen darunterliegenden Lunker überhitzt, geht also in die Eigenleitung, so übernimmt der betroffene Teil nahezu den insgesamt möglichen Strom, die Engstelle(n) brennt (brennen) durch. Damit ist die Zelle, in der der zerstörte Teil liegt, von dem gesund gebliebenen Rest des Leistungstransistors abgetrennt. Damit jetzt die mit ihrem Emitter verschmolzene Basis der zerstörten Zelle dem gesund gebliebenen Rest des Leistungstransistors nicht den Basisstrom wegnimmt, dienen im einfachsten Fall Widerstände zwischen den Basisleitungen und der Schaltung, die den Ansteuerstrom liefert.

Figur 1 zeigt eine Anordnung, die nicht ein Ausführungsbeispiel der Erfindung ist aber zum besseren Verständnis der Erfindung dient.

In Figur 1 ist 31 eine Sammelleitung für die Emitter der Zellen, wobei auch einzelne Anschlußflecken 31/1 bzw. 31/2 usw. für die Emitter möglich sind, falls sich die Sammelleitung für die Emitter außerhalb des Chips befindet; ebenso ist 41 eine Sammelleitung für die Kollektoren der Zellen, bei denen ebenfalls einzelne Anschlußflecken 41/1, 41/2 usw. möglich sind, falls sich die Sammelleitung für die Kollektoren außerhalb des Chips befindet. Ferner sind 52/1 und 52/2 die Transistoren der ersten beiden Zellen. Der Verband setzt sich nach rechs weiter fort. Die Kollektoren sind mittels der Leitungen 43/1, 43/2 usw., die die Brennstrecken 44/1, 44/2 enthalten, mit der Sammelleitung 41 bzw. den Anschlußflecken 41/1, 41/2 usw. verbunden. Die Leitung 85 ist die Sammelleitung für die Basisansteuerung des Leistungstransistors. Zwischen ihr und den Basen der Teiltransistoren der Zellen sind die Entkopplungswiderstände 45/1, 45/2 usw. geschaltet. Diese Widerstände verhindern, daß der Basisstrom der Sammelleitung 85 über eine zerstörte Basis-Emitter-Strecke zum Minuspol 31 abfließen kann.

In Figur 2 ist 54/1 ein Treibertransistor, 47/1 sein an der Sammelleitung für die Betriebsspannung angeschlossener Kollektorwiderstand und 46/1 der in diesem Fall seiner Basis vorgeschaltete Entkopplungswiderstand. Dieser könnte mit einem anderen Widerstandswert auch zwischen seinem Emitter und der Basis des Transistors 52/1 liegen.

In Figur 3 ist 42/1 eine Brennstrecke zur Entkopplung der zerstörten Basis-Emitter-Strecke des Transistors 52/1. Das Schaltelement 57/1 ist ein Thyristor, der mit seiner Anode an die Sammelleitung 41 der Kollektoren und mit seiner Kathode an das der Basis abgewandte Ende der Brennstrecke 42/1 angeschlossen ist. Seine Zündelektrode 571/1 wirkt gegen die Anode. Sie liegt über den Widerstand 49/1 direkt am Kollektor von 52/1. Wird diese Zelle zerstört, so brennt die Brennstrecke 44/1 durch, das Kollektorpotential geht auf Emitterpotential. Der Thyristor 57/1 wird gezündet (sofern der Verbund des Leistungstransistors sich außerhalb der Sättigung befindet). Damit brennt auch die Brennstrecke 42/1 durch, die kurzgeschlossene Basis-Emitter-Strecke ist abgetrennt.

Im Ausführungsbeispiel nach Figur 4 ist 55/1 ein Thyristor, der mit seiner Anode an die Sammelleitung 86 für die Betriebsspannung, mit seiner Kathode wieder an die der Basis abgewandte Seite der Brennstrecke angeschlossen ist. Seine der Kathode zugewandte Zündelektrode 572/1 ist mit dem Kollektor des pnp-Transistors 56/1 verbunden, der wiederum mit seinem Emitter an der Sammelleitung der Kollektorstrecke und mit seiner Basis über den Widerstand 48/1 mit dem Kollektor von 52/1 verbunden ist. Der Zündmechanismus des Thyristors entspricht wieder dem nach Figur 3. Die Widerstände 46/1, 46/X,... sollen in den Ausführungen nach den Figuren 3 und 4 nicht mehr die Ansteuerung entkoppeln, sondern eine Beschädigung der Basis-Emitter-Strecken der Treibertransistoren 54/X während des Durchbrennens der Brennstrecken 42/X verhindern; sie sind nicht grundsätzlich erforderlich.

Die Brennstrecken in den Kollektorleitungen der Zellen erscheinen zunächst nachteilig, da hierzu die Zellen gegeneinander isoliert werden müssen. Bei Leistungstransistoren mit hoher Verlustleistung ist dies jedoch kein Nachteil, da die Chipfläche von der Verlustleistung her bestimmt wird und somit die gegenseitige Isolation der Zellen flächenneutral ausgeführt werden kann. Durch die gegenseitige Isolation der Zellen ergeben sich andere Freiheitsgrade für den Einsatz des so ausgeführten Leistungstransistors.

## Patentansprüche

1. Monolithisch integrierter, in Bipolar-Epitaxial-Technik ausgeführter Leistungstransistor, bestehend aus der Parallelschaltung einer Vielzahl einzelner Transistorzellen, die jeweils mindestens einen Teiltransistor enthalten, wobei in der Emitter-Kollektor-Strecke der Teiltransistoren Brennstrecken (44/1, 44/2, ..., 44/n) vorgesehen sind, daß die Brennstrecken (44/1, 44/2, ..., 44/n) so dimensioniert sind, daß beim Auftreten eines Defekts in einem Teiltransistor (52/1, 52/2, ..., 52/n) bzw. in einer Transistorzelle die dem betreffenen Teiltransistor bzw. der betreffenden Transistorzelle zugeordnete (44/1, 44/2, ..., 44/n) Brennstrecke abbrennt, dadurch gekennzeichnet, daß die Kollektoren der Teiltransistoren gegeneinander isoliert sind, daß die Brennstrecken (44/1, 44/2, ..., 44/n) in die Leitungszüge (43/1, 43/2, ..., 43/n), welche den Kollektoranschluß einer jeden Zelle mit dem allen Zellen gemeinsamen Leitungszug (41) für den äußeren Anschluß des Kollektors des Leistungstransistors bzw. den Kollektoranschluß einer jeden Zelle mit entsprechenden, nach außen führenden Kollektoranschlußflecken (41/1, 41/2, ..., 41/n) verbinden, geschaltet sind, daß den Teiltransistoren (52/1, 52/2, ..., 52/n) Treibertransistoren (54/1, 54/X, ...) vorgeordnet sind,
und daß Widerstände (46/1, 46/X, ...) zwischen den Basen der Treibertransistoren (54/1, 54/X,...) und der Sammelleitung (85) für den Basisanschluß des Leistungstransistors zum Entkoppeln der kurzgeschlossenen Basis-Emitter-Strecke einer zerstörten und kollektorseitig abgetrennten Zelle gegen den intaktgebliebenen Rest des Leistungstransistors angeordnet sind.

2. Monolithisch integrierter, in Bipolar-Epitaxial-Technik. ausgeführter Leistungstransistor, bestehend aus der Parallelschaltung einer. Vielzahl einzelner Transistorzellen, die jeweils mindestens einen Teiltransistor enthalten, wobei in der Emitter-Kollektor-Strecke der Teiltransistoren Brennstrecken (44/1, 44/2, ..., 44/n) vorgesehen sind, daß die Brennstrecken (44/1, 44/2, ..., 44/n) so dimensioniert sind, daß beim Auftreten eines Defekts in einem Teiltransistor (52/1, 52/2, ..., 52/n) bzw. in einer Transistorzelle die dem betreffenen Teiltransistor bzw. der betreffenden Transistorzelle zugeordnete (44/1, 44/2, ..., 44/n) Brennstrecke abbrennt, dadurch gekennzeichnet, daß die Kollektoren der Teiltransistoren gegeneinander isoliert sind, daß die Brennstrecken (44/1, 44/2, ..., 44/n) in die Leitungszüge (43/1, 43/2, .., 43/n), welche den Kollektoranschluß einer jeden Zelle mit dem allen Zellen gemeinsamen Leitungszug (41) für den äußeren Anschluß des Kollektors des Leistungstransistors bzw. den Kollektoranschluß einer jeden Zelle mit entsprechenden, nach außen führenden Kollektoranschlußflecken (41/1, 41/2, ..., 41/n) verbinden, geschaltet sind, daß den Teiltransistoren (52/1, 52/2, ..., 52/n) Treibertransistoren (54/1, 54/X, ...) vorgeordnet sind,
und daß Widerstände (45/1, 45/X, ...) zwischen den Basen der Teiltransistoren (52/1, 52/X ...) und den Emittern der Treibertransistoren (54/1, 54/X, ...) zum Entkoppeln der kurzgeschlossenen Basis-Emitter-Strecke einer zerstörten und kollektorseitig abgetrennten Zelle gegen den intaktgebliebenen Rest des Leistungstransistors angeordnet sind.

## Revendications

1. Transistor de puissance, monolithique, intégré, réalisé en technique bipolaire épitaxiale, comprenant :
- un montage en parallèle d'un grand nombre de cellules de transistor, distinctes, comportant chacune au moins un transistor partiel,
- le chemin émetteur-collecteur des transistors partiels comportant des chemins fusibles (44/1, 44/2, ..., 44/n) ,
- les chemins fusibles (44/1, 44/2, ..., 44/n) étant dimensionnés pour qu'en cas de défaut dans un transistor partiel (52/1, 52/2, ..., 52/n) ou dans une cellule de transistor, le chemin fusible associé au transistor partiel concerné ou à la cellule de transistor concernée (44/1, 44/2, ..., 44/n) brûle,
caractérisé en ce que
- les collecteurs des transistors partiels sont isolés les uns par rapport aux autres,
- les chemins fusibles (44/1, 44/2, ..., 44/n) sont branchés dans des lignes (43/1, 43/2, ..., 43/n), qui relient la borne de collecteur de chaque cellule à la ligne (41) commune à toutes les cellules pour le branchement vers l'extérieur du collecteur du transistor de puissance, ou la borne de collecteur de chaque cellule aux taches de branchement de collecteur (41/1, 41/2, ..., 41/n) correspondantes conduisant à l'extérieur,
- les transistors partiels (52/1, 52/2, ..., 52/n) sont précédés par des transistors pilotes (54/1,/X, ...), et
- des résistances (46/1, 46/X, ...) sont prévues entre la base des transistors pilotes (54/1, 54/X, ...) et la ligne collectrice (85) pour le branchement de la base du transistor de puissance, pour découpler le chemin base/émetteur en court-circuit d'une cellule détruite et coupée du côté du collecteur, vis-à-vis du reste intact du transistor de puissance.

2. Transistor de puissance monolithique, intégré, réalisé en technique bipolaire épitaxiale, comprenant :
- un montage en parallèle d'un grand nombre de cellules de transistor, distinctes, comportant chacune au moins un transistor partiel,
- le chemin émetteur/collecteur des transistors partiels comportant des chemins fusibles (44/1, 44/2, ..., 44/n),
- les chemins fusibles (44/1, 44/2, ..., 44/n) étant dimensionnés pour que lorsque se produit un défaut dans un transistor partiel (52/1, 52/2, ..., 52/n), ou dans une cellule de transistor, le chemin fusible associé au transistor partiel ou à la cellule de transistor concernée (44/1, 44/2, ..., 44/n), brûle,
caractérisé en ce que
- les collecteurs des transistors partiels sont isolés les uns par rapport aux autres,
- les chemins fusibles (44/1, 44/2, ..., 44/n) sont branchés dans des lignes (43/1, 43/2, ..., 43/n), qui relient la borne de collecteur de chaque cellule à la ligne (41) commune à toutes les cellules pour le branchement extérieur du collecteur du transistor de puissance, ou la borne de collecteur de chaque cellule, avec les taches de borne de collecteur (41/1, 41/2, ..., 41/n) aboutissant à l'extérieur,
- des transistors pilotes (54/1, 54/X, ...) sont prévus en amont des transistors partiels (52/1, 52/2, ..., 52/n), et
- des résistances (45/1, 45/X, ...) sont prévues entre les bases des transistors partiels (52/1, 52/X, ...) et les émetteurs des transistors pilotes (54/1, 54/X, ...) pour découpler le chemin base/émetteur en court-circuit d'une cellule détruite et brûlée du côté du collecteur, par rapport au reste intact du transistor de puissance.

## Claims

1. Monolithically integrated power transistor which is constructed using a bipolar epitaxial technique, composed of the parallel connection of a multiplicity of individual transistor cells which each contain at least one component transistor, burning sections (44/1, 44/2, ... 44/n) being provided in the emitter/collector path of the component transistors and the burning paths (44/1, 44/2, ... 44/n) being dimensioned in such a way that when a defect occurs in a component transistor (52/1, 52/2, ... 52/n) or in a transistor cell, the burning path (44/1, 44/2, ... 44/n) assigned to the respective component transistor or to the respective transistor cell burns away, characterized in that the collectors of the component transistors are insulated from one another, in that the burning paths (44/1, 44/2, ... 44/n) are connected into the line sections (43/1, 43/2, ... 43/n) which connect the collector terminal of each cell to the line section (41) which is common to all the cells, in order to externally connect the collector of the power transistor, or connect the collector terminal of each cell to corresponding collector connecting pads (41/1, 41/2, ... 41/n) which lead to the outside, in that driver transistors (54/1, 54/X, ...) are arranged upstream of the component transistors (52/1, 52/2, ... 52/n), and in that resistors (46/1, 46/X, ...) are arranged between the bases of the driver transistors (54/1, 54/X, ...) and the collector line (85) for the base terminal of the power transistor in order to isolate the short-circuited base/emitter path of a damaged cell which has become disconnected on the collector side from the rest of the power transistor which has remained intact.

2. Monolithically integrated power transistor which is constructed using a bipolar epitaxial technique, composed of the parallel connection of a multiplicity of individual transistor cells which each contain at least one component transistor, burning sections (44/1, 44/2, ... 44/n) being provided in the emitter/collector path of the component transistors and the burning paths (44/1, 44/2, ... 44/n) being dimensioned in such a way that when a defect occurs in a component transistor (52/1, 52/2, ... 52/n) or in a transistor cell, the burning path (44/1, 44/2, ... 44/n) assigned to the respective component transistor or to the respective transistor cell burns away, characterized in that the collectors of the component transistors are insulated from one another, in that the burning paths (44/1, 44/2, ... 44/n) are connected into the line sections (43/1, 43/2, ... 43/n) which connect the collector terminal of each cell to the line section (41) which is common to all the cells, in order to externally connect the collector of the power transistor, or connect the collector terminal of each cell to corresponding collector connecting pads (41/1, 41/2, ... 41/n) which lead to the outside, in that driver transistors (54/1, 54/X, ...) are arranged upstream of the component transistors (52/1, 52/2, ... 52/n), and in that resistors (45/1, 45/X, ...) are arranged between the bases of the component transistors (52/1, 52/X, ...) and the emitters of the driver transistors (54/1, 54/X, ...) in order to isolate the short-circuited base/emitter path of a damaged cell which has been disconnected on the collector side from the rest of the power transistor which has remained intact.
